# EUROPEAN PATENT APPLICATION

(11) **EP 4 692 936 A1**
(43) Date of publication of application: **11.02.2026**
(21) Application number: 24897505.4
(22) Date of filing: 25.11.2024
(51) Int. Cl.: G03F 7/031, G03F 7/004, G03F 7/033

(54) **PHOTOSENSITIVE RESIN COMPOSITION, PHOTOSENSITIVE ELEMENT, METHOD FOR FORMING RESIST PATTERN, AND METHOD FOR PRODUCING PRINTED WIRING BOARD**

(30) Priority: 30.11.2023 WO PCT/JP2023/043023
(71) Applicant: Resonac Corporation, Tokyo 105-7325 (JP)
(72) Inventor: TODA, Natsuki, Tokyo 105-7325 (JP); SAWAKI, Taku, Tokyo 105-7325 (JP); ONO, Akane, Tokyo 105-7325 (JP); SAKASHITA, Yusuke, Tokyo 105-7325 (JP); KATO, Tetsuya, Tokyo 105-7325 (JP); ONO, Hiroshi, Tokyo 105-7325 (JP); KAGUCHI, Yosuke, Tokyo 105-7325 (JP)
(74) Representative: Hoffmann Eitle
(86) International application number: PCT/JP2024/041691
(87) International publication number: WO 2025/115820

(57) **Abstract**

A photosensitive resin composition according to an aspect of the present disclosure contains a binder polymer, a photopolymerizable compound, a photopolymerization initiator, and a sensitizer, in which the binder polymer has a structural unit derived from acrylic acid, and a content of the sensitizer is less than 0.01 parts by mass with respect to 100 parts by mass of a total amount of the binder polymer and the photopolymerizable compound.

## Description

### Technical Field

The present disclosure relates to a photosensitive resin composition, a photosensitive element, a method for forming a resist pattern, and a method for producing a printed wiring board.

### Background Art

In the field of printed wiring board production, as resist materials used for an etching treatment or a plating treatment, photosensitive resin compositions and photosensitive elements including a support and a layer formed on the support using a photosensitive resin composition (hereinafter, also referred to as "photosensitive layer") are widely used (see, for example, the following Patent Literatures 1 and 2).

A printed wiring board is produced, for example, using the above-described photosensitive element by the following procedure. First, a photosensitive layer of a photosensitive element is laminated on a substrate for circuit formation such as a copper-clad laminated plate. Next, predetermined portions of the photosensitive layer are exposed to light through a photomask, and photocured parts are formed. At this time, the support is peeled before the exposure or after the exposure. Thereafter, regions other than the photocured parts in the photosensitive layer are removed using a developing solution, and a resist pattern is formed on the substrate. Next, the resist pattern is used as a resist and is subjected to an etching treatment or a plating treatment to form a conductor pattern (conductor layer) on the substrate, and finally the resist is removed.

### Citation List

### Patent Literature

Patent Literature 1: Japanese Unexamined Patent Publication No. 2009-003177
Patent Literature 2: Japanese Unexamined Patent Publication No. 2013-061556

### Summary of Invention

### Technical Problem

In recent years, it has been investigated that in electronic components such as inductors, the thickness of the conductor layer is made larger to form a wiring pattern with a high aspect ratio. For that reason, there is a demand for a photosensitive resin composition that can form a resist pattern of a thick film (for example, having a film thickness of 30 µm or more). However, in conventional photosensitive resin compositions, when the thickness of the photosensitive layer is made larger, it is difficult for light to penetrate to the bottom part of the photosensitive layer, adhesiveness and the like are deteriorated, and it is difficult to form a resist pattern having a high aspect ratio. Furthermore, when the thickness of the photosensitive layer is made larger, the developing time and the releasing time tend to become longer. In order to shorten the developing time and the peeling time and increase the production efficiency, there is a demand for a photosensitive resin composition having excellent developability and releasability.

It is an object of the present disclosure to provide a photosensitive resin composition that has excellent developability and releasability and can form a resist pattern having a high aspect ratio, a photosensitive element, and a method for forming a resist pattern and a method for producing a printed wiring board, which methods use the photosensitive resin composition and the photosensitive element.

### Solution to Problem

In order to achieve the above-described object, an aspect of the present disclosure relates to the following photosensitive resin composition, photosensitive element, method for forming a resist pattern, and method for producing a printed wiring board.
[1] A photosensitive resin composition containing:
   a binder polymer;
   a photopolymerizable compound;
   a photopolymerization initiator; and
   a sensitizer,
   wherein the binder polymer has a structural unit derived from acrylic acid, and a content of the sensitizer is less than 0.01 parts by mass with respect to 100 parts by mass of a total amount of the binder polymer and the photopolymerizable compound.
[2] The photosensitive resin composition according to the above-described item [1], wherein the content of the sensitizer is 0.65 parts by mass or less with respect to 100 parts by mass of a total amount of the photopolymerization initiator.
[3] The photosensitive resin composition according to the above-described item [1] or [2], wherein the content of the sensitizer is 0.001 parts by mass or more with respect to 100 parts by mass of the total amount of the binder polymer and the photopolymerizable compound.
[4] The photosensitive resin composition according to any one of the above-described items [1] to [3], wherein the binder polymer further has at least one selected from the group consisting of a structural unit derived from styrene or a styrene derivative, and a structural unit derived from a (meth)acrylate compound having an alicyclic structure.
[5] The photosensitive resin composition according to any one of the above-described items [1] to [4], wherein the sensitizer includes at least one selected from the group consisting of a dialkylaminobenzophenone compound, a pyrazoline compound, and an anthracene compound.
[6] A photosensitive element including:
   a support; and
   a photosensitive layer formed on the support using the photosensitive resin composition according to any one of the above-described items [1] to [5].
[7] The photosensitive element according to the above-described item [6], wherein the photosensitive layer has a thickness of 30 µm or more.
[8] A method for forming a resist pattern, the method including:
   a step of forming a photosensitive layer on a substrate by using the photosensitive resin composition according to any one of the above-described items [1] to [5];
   a step of irradiating at least a portion of the photosensitive layer with active light rays to form a photocured part; and
   a step of removing a non-photocured part of the photosensitive layer from the substrate to form a resist pattern.
[9] A method for forming a resist pattern, the method including:
   a step of forming a photosensitive layer on a substrate by using the photosensitive element according to the above-described item [6] or [7];
   a step of irradiating at least a portion of the photosensitive layer with active light rays to form a photocured part; and
   a step of removing a non-photocured part of the photosensitive layer from the substrate to form a resist pattern.
[10] A method for producing a printed wiring board, the method including:
   a step of subjecting a substrate on which a resist pattern has been formed by the method for forming a resist pattern according to the above-described item [8] or [9] to an etching treatment or a plating treatment to form a conductor pattern.

### Advantageous Effects of Invention

According to the present disclosure, a photosensitive resin composition that has excellent developability and releasability and can form a resist pattern with a high aspect ratio, a photosensitive element, and a method for forming a resist pattern and a method for producing a printed wiring board, which methods use the photosensitive resin composition and the photosensitive element can be provided.

### Brief Description of Drawings

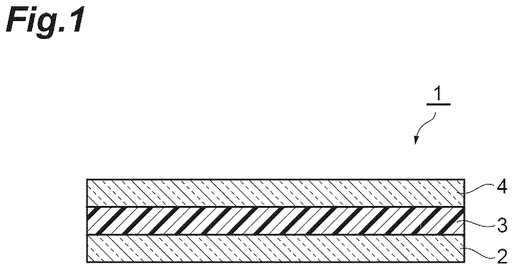

[Fig. 1] Fig. 1 is a schematic cross-sectional view illustrating an embodiment of a photosensitive element.

### Description of Embodiments

Hereinafter, embodiments for carrying out the present disclosure will be described in detail. However, the present invention is not intended to be limited to the following embodiments.

According to the present specification, the term "step" refers not only to an independent step, but a step that cannot be clearly distinguished from other steps is also included in the present term as long as the intended action of the step is achieved. The term "layer" includes a structure having a shape formed over the entire surface as well as a structure having a shape formed on a part, when viewed in a plan view. A numerical value range indicated using the term "to" indicates a range including the numerical values described before and after the term "to" as the minimum value and the maximum value, respectively. With regard to a numerical value range described in stages in the present specification, the upper limit value or lower limit value of a numerical value range of a certain stage may be replaced with the upper limit value or lower limit value of a numerical value range of another stage. With regard to a numerical value range described in the present specification, the upper limit value or lower limit value of the numerical value range may be replaced with a value shown in the Examples.

In the present specification, the term "(meth)acrylate" means at least one of "acrylate" and its corresponding "methacrylate". The same also applies to other similar expressions such as (meth)acryloyl.

In the present specification, the amount of each component in a photosensitive resin composition means, in a case where there are a plurality of substances corresponding to each component in the composition, the total amount of the plurality of substances present in the present composition, unless particularly stated otherwise. In the present specification, the term "solid content" refers to the non-volatile content in the photosensitive resin composition, excluding volatile substances (water, solvent, and the like). That is, the term "solid content" refers to components other than solvents, which do not evaporate during drying of the photosensitive resin composition that will be described below, and also include components that are liquid, syrup-like, or wax-like at room temperature (25°C).

### [Photosensitive resin composition]

A photosensitive resin composition according to the present embodiment contains: (A) a binder polymer (hereinafter, sometimes referred to as "component (A)"); (B) a photopolymerizable compound (hereinafter, sometimes referred to as "component (B)"; (C) a photopolymerization initiator (hereinafter, sometimes referred to as "component (C)"); and (D) a sensitizer (hereinafter, sometimes referred to as "component (D)"). The component (A) has a structural unit derived from acrylic acid, and the content of the component (D) is less than 0.01 parts by mass with respect to 100 parts by mass of the total amount of the component (A) and the component (B). The photosensitive resin composition according to the present embodiment can exhibit excellent developability and releasability and can form a resist pattern with a high aspect ratio by using such a specific binder polymer and a specific amount of a sensitizer in combination, and therefore, the photosensitive resin composition can be suitably used for thick film applications. Hereinafter, each component that can be contained in the photosensitive resin composition will be described in detail.

### Component (A): Binder polymer

The photosensitive resin composition contains one kind or two or more kinds of component (A). The component (A) has a structural unit derived from acrylic acid (hereinafter, sometimes referred to as "first structural unit"). The component (A) can be produced by radical polymerizing polymerizable monomers including acrylic acid.

The photosensitive resin composition according to the present embodiment can improve the developability and releasability after curing of the photosensitive layer formed from the photosensitive resin composition, by containing a binder polymer that has the first structural unit as the component (A). Acrylic acid has a lower glass transition temperature and is more flexible as compared with methacrylic acid. The inventors of the present invention found that, by using acrylic acid as a polymerizable monomer, the glass transition temperature of the resulting binder polymer can be lowered, and the developability and releasability of the photosensitive resin composition can be improved.

The content of the first structural unit in the component (A) may be 15% by mass or more, 18% by mass or more, 19% by mass or more, or 20% by mass or more from the viewpoint of sensitivity, developability, adhesiveness, and releasability, and may be 27% by mass or less, 26% by mass or less, 25% by mass or less, or 24% by mass or less from the viewpoint of alkali resistance, all based on the total mass of the structural units derived from the polymerizable monomers constituting the binder polymer. The content of the first structural unit in the component (A) may be 15% by mass to 27% by mass, 18% by mass to 26% by mass, 19% by mass to 25% by mass, or 20% by mass to 24% by mass, based on the total mass of the structural units derived from the polymerizable monomers constituting the binder polymer.

From the viewpoint of improving the resolution and adhesiveness of the photosensitive resin composition and at the same time, reducing the amount of resist skirt generation, the component (A) may have a structural unit derived from styrene or a styrene derivative (hereinafter, sometimes referred to as "second structural unit"). Examples of the styrene derivative include vinyltoluene, α-methylstyrene, p-methylstyrene, and p-ethylstyrene.

The content of the second structural unit in the component (A) based on the total mass of the structural units derived from the polymerizable monomers constituting the binder polymer may be, from the viewpoint of improving the resolution and adhesiveness and at the same time, reducing the amount of resist skirt generation, 55% by mass or more, 60% by mass or more, 65% by mass or more, or 68% by mass or more, and from the viewpoint that the developing time is appropriately short and the development residue is less likely to occur, the content may be 84% by mass or less, 80% by mass or less, 78% by mass or less, or 75% by mass or less. When the component (A) has the second structural unit, from the viewpoint of developability, releasability, and a high aspect ratio, the mass ratio of the second structural unit to the first structural unit (mass of second structural unit/mass of first structural unit) may be 2.5 or more, 2.8 or more, or 3.0 or more, and may be 3.5 or less or 3.3 or less.

From the viewpoint of the resolution and adhesiveness of the photosensitive resin composition, the component (A) may have a structural unit derived from a (meth)acrylate compound having an alicyclic structure (hereinafter, sometimes referred to as "third structural unit"). Examples of the (meth)acrylate having an alicyclic structure include cyclohexyl (meth)acrylate, isobornyl (meth)acrylate, adamantyl (meth)acrylate, cyclopentanyl (meth)acrylate, and dicyclopentanyl (meth)acrylate.

The content of the third structural unit in the component (A) based on the total mass of the structural units derived from the polymerizable monomers constituting the binder polymer may be, from the viewpoint of further improving the resolution and adhesiveness of the photosensitive resin composition, 0.5% by mass or more, 0.8% by mass or more, 1.0% by mass or more, 2.0% by mass or more, 3.0% by mass or more, or 4.0% by mass or more, and from the viewpoint of further improving the developability of the photosensitive resin composition, the content may be 20% by mass or less, 18% by mass or less, 16% by mass or less, 14% by mass or less, or 12% by mass or less.

The component (A) may further have a structural unit derived from a polymerizable monomer other than those described above (hereinafter, also referred to as "other monomer"), to the extent that does not interfere with the effects of the present disclosure. Examples of the other monomer include methacrylic acid, 2-ethylhexyl (meth)acrylate, hydroxyethyl (meth)acrylate, benzyl (meth)acrylate or a derivative thereof, furfuryl (meth)acrylate, tetrahydrofurfuryl (meth)acrylate, dimethylaminoethyl (meth)acrylate, diethylaminoethyl (meth)acrylate, glycidyl (meth)acrylate, 2,2,2-trifluoroethyl (meth)acrylate, 2,2,3,3-tetrafluoropropyl (meth)acrylate, β-furyl (meth)acrylic acid, β-styryl (meth)acrylic acid, maleic acid, maleic anhydride, maleic acid monoalkyl ester, fumaric acid, cinnamic acid, α-cyanocinnamic acid, itaconic acid, crotonic acid, and propiolic acid. These can be used singly or in combination of two or more kinds thereof. From the viewpoint of having more excellent developability and releasability, the component (A) does not have to contain a structural unit derived from methacrylic acid.

The weight average molecular weight (Mw) of the component (A) may be 20000 or more, 25000 or more, 30000 or more, or 35000 or more, and may be 80000 or less, 70000 or less, 60000 or less, or 50000 or less. The Mw of the component (A) may be 20000 to 80000, 25000 to 70000, 30000 to 60000, or 35000 to 50000. When the Mw is 80000 or less, resolution and developability tend to be further improved, and when the Mw is 20000 or more, flexibility of the cured film is improved, while there is a tendency that chipping and peeling of the resist pattern are less likely to occur.

The Mw can be measured, for example, by gel permeation chromatography (GPC) using a calibration curve of polystyrene standards. More specifically, the Mw can be measured under the conditions described in the Examples.

The acid value of the component (A) may be 140 mg KOH/g or more, 150 mg KOH/g or more, 160 mg KOH/g or more, or 170 mg KOH/g or more, and may be 230 mg KOH/g or less, 220 mg KOH/g or less, 200 mg KOH/g or less, 190 mg KOH/g or less, 185 mg KOH/g or less, or 180 mg KOH/g or less. From the viewpoint of having more excellent developability and releasability, the acid value of the component (A) may be 140 to 230 mg KOH/g, 140 to 200 mg KOH/g, 150 to 190 mg KOH/g, 160 to 185 mg KOH/g, or 170 to 180 mg KOH/g. When the acid value of the component (A) is 140 mg KOH/g or more, lengthening of the developing time can be more sufficiently suppressed, and when the acid value is 200 mg KOH/g or less, the developing solution resistance (adhesiveness) of a cured product of the photosensitive resin composition is more easily improved. The acid value of the component (A) can be adjusted by the structural unit derived from acrylic acid. The acid value of the component (A) can be measured according to JIS K6901:2008 5.3.2.

The glass transition temperature (Tg) of the component (A) may be 80°C or higher, 90°C or higher, 95°C or higher, or 100°C or higher, and may be 120°C or lower, 113°C or lower, 112°C or lower, 111°C or lower, or 110°C or lower. The Tg of the component (A) may be 80°C to 120°C, 80°C to 113°C, 90°C to 112°C, 95°C to 111°C, or 100°C to 110°C. When the Tg of the component (A) is 80°C or higher, the lamination properties of the photosensitive layer formed from the photosensitive resin composition are likely to be improved, and when the Tg is 120°C or lower, the adhesiveness, resolution, and storage stability of the photosensitive resin composition are likely to be improved. The Tg of the component (A) is a value that can be determined by the Fox equation, and can be calculated from the mass of each of the polymerizable monomers constituting the component (A), and the Tg of a homopolymer of each of the polymerizable monomers.

From the viewpoint that the moldability of the film is excellent, the content of the component (A) may be 20 parts by mass or more, 30 parts by mass or more, 40 parts by mass or more, or 50 parts by mass or more, and from the viewpoint that sensitivity and resolution are further improved, the content may be 80 parts by mass or less, 70 parts by mass or less, or 60 parts by mass or less, with respect to 100 parts by mass of the total amount of the component (A) and the component (B).

### Component (B): Photopolymerizable compound

The photosensitive resin composition contains one kind or two or more kinds of component (B). The component (B) may be a compound that is polymerized by light, and may be, for example, a compound having an ethylenically unsaturated bond. The component (B) may include a polyfunctional monomer having two or more reactive groups that react with radicals. From the viewpoint of developability, resolution, and releasability after curing, the component (B) may include a bisphenol A type (meth)acrylate compound.

Examples of the bisphenol A type (meth)acrylate compound include 2,2-bis(4-((meth)acryloxypolyethoxy)phenyl)propane, 2,2-bis(4-((meth)acryloxypolypropoxy)phenyl)propane, 2,2-bis(4-((meth)acryloxypolybutoxy)phenyl)propane, and 2,2-bis(4-((meth)acryloxypolyethoxypolypropoxy)phenyl)propane. From the viewpoint of resolution and releasability, the component (B) may include 2,2-bis(4-((meth)acryloxypolyethoxy)phenyl)propane. As 2,2-bis(4-((meth)acryloxypolyethoxy)phenyl)propane, a compound in which the number of oxyethylene groups is 10 or more may be used, a compound in which the number of oxyethylene groups is less than 10 may be used, or the compound in which the number of oxyethylene groups is 10 or more and the compound in which the number of oxyethylene groups is less than 10 may be used in combination. Examples of 2,2-bis(4-((meth)acryloxypolyethoxy)phenyl)propane include 2,2-bis(4-((meth)acryloxypentaethoxy)phenyl)propane and 2,2-bis(4-((meth)acryloxydiethoxy)phenyl)propane.

From the viewpoint of resolution, the content of the bisphenol A type (meth)acrylate compound may be 20% by mass or more, 40% by mass or more, 60% by mass or more, or 80% by mass or more, and may be 100% by mass or less or 95% by mass or less, based on the total amount of the component (B). In a case where 2,2-bis(4-((meth)acryloxypolyethoxy)phenyl)propane is used as the bisphenol A type (meth)acrylate compound, the content of the compound in which the number of oxyethylene groups is 10 or more may be 20% by mass or more, 40% by mass or more, 60% by mass or more, or 70% by mass or more, and may be 100% by mass or less, 95% by mass or less, or 90% by mass or less, based on the total amount of the component (B).

From the viewpoint of resolution and flexibility, the component (B) may include an α,β-unsaturated ester compound obtained by reacting a polyhydric alcohol with an α,β-unsaturated carboxylic acid. Examples of the α,β-unsaturated ester compound include polyalkylene glycol di(meth)acrylates such as polyethylene glycol di(meth)acrylate, polypropylene glycol di(meth)acrylate, and EO-modified polypropylene glycol; trimethylolpropane di(meth)acrylate, trimethylolpropane tri(meth)acrylate, EO-modified trimethylolpropane tri(meth)acrylate, PO-modified trimethylolpropane tri(meth)acrylate, EO-PO-modified trimethylolpropane tri(meth)acrylate, tetramethylolmethane tri(meth)acrylate, and tetramethylolmethane tetra(meth)acrylate.

From the viewpoint of sensitivity and adhesiveness, the component (B) may include a compound having three or more (meth)acryloyl groups. Examples of the compound having three or more (meth)acryloyl groups include trimethylolpropane tri(meth)acrylate, EO-modified trimethylolpropane tri(meth)acrylate, PO-modified trimethylolpropane tri(meth)acrylate, EO·PO-modified trimethylolpropane tri(meth)acrylate, EO-modified pentaerythritol tetra(meth)acrylate, EO-modified ditrimethylolpropane tetra(meth)acrylate, and EO-modified dipentaerythritol hexa(meth)acrylate.

The content of the α,β-unsaturated ester compound based on the total amount of the component (B) may be 20% by mass or more, or 30% by mass or more from the viewpoint of flexibility, and may be 70% by mass or less, or 60% by mass or less from the viewpoint of resolution.

The photosensitive resin composition may contain another photopolymerizable compound in addition to the bisphenol A type (meth)acrylate compound and the α,β-unsaturated ester compound as the component (B).

Examples of the other photopolymerizable compound include nonylphenoxy polyethyleneoxy acrylate, a phthalic acid-based compound, a (meth)acrylic acid alkyl ester, and a photopolymerizable compound having at least one cationically polymerizable cyclic ether group in the molecule (an oxetane compound or the like). From the viewpoint of the resolution, adhesiveness, resist shape, and releasability after curing, the other photopolymerizable compound may be at least one selected from the group consisting of nonylphenoxy polyethyleneoxy acrylate and a phthalic acid-based compound.

Examples of nonylphenoxy polyethyleneoxy acrylate include nonylphenoxy triethyleneoxy acrylate, nonylphenoxy tetraethyleneoxy acrylate, nonylphenoxy pentaethyleneoxy acrylate, nonylphenoxy hexaethyleneoxy acrylate, nonylphenoxy heptaethyleneoxy acrylate, nonylphenoxy octaethyleneoxy acrylate, nonylphenoxy nonaethyleneoxy acrylate, nonylphenoxy decaethyleneoxy acrylate, and nonylphenoxy undecaethyleneoxy acrylate.

Examples of the phthalic acid-based compound include γ-chloro-β-hydroxypropyl-β'-(meth)acryloyloxyethyl-o-phthalate (also known as 3-chloro-2-hydroxypropyl-2-(meth)acryloyloxyethyl phthalate), β-hydroxyethyl-β'-(meth)acryloyloxyethyl-o-phthalate, and β-hydroxypropyl-β'-(meth)acryloyloxyethyl-o-phthalate.

When the component (B) includes another photopolymerizable compound, from the viewpoint of the resolution, adhesiveness, resist shape, and releasability after curing, the content of the other photopolymerizable compound may be 1% by mass or more, 3% by mass or more, or 5% by mass or more, and may be 30% by mass or less, 25% by mass or less, or 20% by mass or less, based on the total amount of the component (B).

Among the above-mentioned compounds, the component (B) may include a compound having a total of 2 to 40 oxyethylene groups (EO groups) and/or oxypropylene groups (PO groups) in the molecule, from the viewpoint of adhesiveness and resolution. The total number of EO groups and/or PO groups may be 2 to 40 or 2 to 30, from the viewpoint of adhesiveness and resolution.

The content of the compound having a total of 2 to 40 EO groups and/or PO groups may be 2% to 15% by mass, 4% to 12% by mass, or 5% to 8% by mass, based on the total amount of the component (B), from the viewpoint of adhesiveness and resolution.

The content of the component (B) based on the total amount of the solid content of the photosensitive resin composition may be 3% by mass or more, 10% by mass or more, or 25% by mass or more from the viewpoint of sensitivity and resolution, and may be 70% by mass or less, 60% by mass or less, or 50% by mass or less from the viewpoint of film moldability.

### Component (C): Photopolymerization initiator

The photosensitive resin composition contains one kind or two or more kinds of component (C). The component (C) is not particularly limited as long as it can polymerize the component (B), and can be appropriately selected from those conventionally used photopolymerization initiators.

Examples of the component (C) include hexaarylbiimidazole compounds; aromatic ketone compounds such as benzophenone, 2-benzyl-2-dimethylamino-1-(4-morpholinophenyl)-1-butanone, 2-(dimethylamino)-2-[(4-methylphenyl)methyl]-1-[4-(4-morpholinyl)p henyl]-1-butanone, 4-(2-hydroxyethoxy)phenyl-2-(hydroxy-2-propyl) ketone, and 2-methyl-1-[4-(methylthio)phenyl]-2-morpholinopropanone-1; quinone compounds such as an alkyl anthraquinone; benzoin ether compounds such as a benzoin alkyl ether; benzoin compounds such as benzoin and an alkylbenzoin; benzyl derivatives such as benzyl dimethyl ketal; and phosphine oxide compounds such as bis(2,4,6-trimethylbenzoyl)-phenylphosphine oxide, bis(2,6-dimethylbenzoyl)-2,4,4-trimethyl-pentylphosphine oxide, and (2,4,6-trimethylbenzoyl)ethoxyphenylphosphine oxide.

From the viewpoint that penetration of a photosensitizer into a polyethylene film can be suppressed, the component (C) may include a hexaarylbiimidazole compound. The aryl group in the hexaarylbiimidazole compound may be a phenyl group or the like. A hydrogen atom bonded to the aryl group in the hexaarylbiimidazole compound may be substituted with a halogen atom (a chlorine atom or the like).

The hexaarylbiimidazole compound may be a 2,4,5-triarylimidazole dimer. Examples of the 2,4,5-triarylimidazole dimer include 2-(o-chlorophenyl)-4,5-diphenylimidazole dimer, 2-(o-chlorophenyl)-4,5-bis(m-methoxyphenyl)imidazole dimer, and 2-(p-methoxyphenyl)-4,5-diphenylimidazole dimer. From the viewpoint that penetration of a photosensitizer into a polyethylene film can be further suppressed, the hexaarylbiimidazole compound is preferably 2-(o-chlorophenyl)-4,5-diphenylimidazole dimer, and more preferably 2,2-bis(o-chlorophenyl)-4,5-4',5'-tetraphenyl-1,2'-biimidazole.

The content of the hexaarylbiimidazole compound may be 90% by mass or more, 95% by mass or more, or 99% by mass or more, based on the total amount of the component (C). The component (C) may be composed only of the hexaarylbiimidazole compound.

From the viewpoint of sensitivity and adhesiveness, the content of the component (C) may be 0.1% by mass or more, 0.5% by mass or more, or 1.0% by mass or more, and may be 20% by mass or less, 10% by mass or less, or 5% by mass or less, based on the total amount of the solid content of the photosensitive resin composition.

### Component (D): Sensitizer

The photosensitive resin composition includes one kind or two or more kinds of component (D). Examples of the component (D) include a dialkylaminobenzophenone compound, a pyrazoline compound, an anthracene compound, a coumarin compound, a xanthone compound, a thioxanthone compound, an oxazole compound, a benzoxazole compound, a thiazole compound, a benzothiazole compound, a triazole compound, a stilbene compound, a triazine compound, a thiophene compound, a naphthalimide compound, a triarylamine compound, and an aminoacridine compound.

Examples of the dialkylaminobenzophenone compound include
4,4'-bis(dimethylamino)benzophenone and
4,4'-bis(diethylamino)benzophenone.

Examples of the pyrazoline compound include
1-(4-methoxyphenyl)-3-styryl-5-phenyl-pyrazoline,
1-phenyl-3-(4-methoxystyryl)-5-(4-methoxyphenyl)-pyrazoline,
1,5-bis-(4-methoxyphenyl)-3-(4-methoxystyryl)-pyrazoline,
1-(4-isopropylphenyl)-3-styryl-5-phenyl-pyrazoline,
1-phenyl-3-(4-isopropylstyryl)-5-(4-isopropylphenyl)-pyrazoline,
1,5-bis-(4-isopropylphenyl)-3-(4-isopropylstyryl)-pyrazoline,
1-(4-methoxyphenyl)-3-(4-tert-butylstyryl)-5-(4-tert-butyl-phenyl)-pyr azoline,
1-(4-tert-butyl-phenyl)-3-(4-methoxystyryl)-5-(4-methoxyphenyl)-pyra zoline,
1-(4-isopropyl-phenyl)-3-(4-tert-butylstyryl)-5-(4-tert-butyl-phenyl)-py razoline,
1-(4-tert-butyl-phenyl)-3-(4-isopropylstyryl)-5-(4-isopropyl-phenyl)-py razoline,
1-(4-methoxyphenyl)-3-(4-isopropylstyryl)-5-(4-isopropylphenyl)-pyra zoline,
1-(4-isopropyl-phenyl)-3-(4-methoxystyryl)-5-(4-methoxyphenyl)-pyra zoline,
1-phenyl-3-(3,5-dimethoxystyryl)-5-(3,5-dimethoxyphenyl)-pyrazoline,
1-phenyl-3-(3,4-dimethoxystyryl)-5-(3,4-dimethoxyphenyl)-pyrazoline,
1-phenyl-3-(2,6-dimethoxystyryl)-5-(2,6-dimethoxyphenyl)-pyrazoline,
1-phenyl-3-(2,5-dimethoxystyryl)-5-(2,5-dimethoxyphenyl)-pyrazoline,
1-phenyl-3-(2,3-dimethoxystyryl)-5-(2,3-dimethoxyphenyl)-pyrazoline,
1-phenyl-3-(2,4-dimethoxystyryl)-5-(2,4-dimethoxyphenyl)-pyrazoline,
1-(4-methoxyphenyl)-3-(3,5-dimethoxystyryl)-5-(3,5-dimethoxyphenyl )-pyrazoline,
1-(4-methoxyphenyl)-3-(3,4-dimethoxystyryl)-5-(3,4-dimethoxyphenyl )-pyrazoline,
1-(4-methoxyphenyl)-3-(2,6-dimethoxystyryl)-5-(2,6-dimethoxyphenyl )-pyrazoline,
1-(4-methoxyphenyl)-3-(2,5-dimethoxystyryl)-5-(2,5-dimethoxyphenyl )-pyrazoline,
1-(4-methoxyphenyl)-3-(2,3-dimethoxystyryl)-5-(2,3-dimethoxyphenyl )-pyrazoline,
1-(4-methoxyphenyl)-3-(2,4-dimethoxystyryl)-5-(2,4-dimethoxyphenyl )-pyrazoline,
1-(4-tert-butyl-phenyl)-3-(3,5-dimethoxystyryl)-5-(3,5-dimethoxyphen yl)-pyrazoline,
1-(4-tert-butyl-phenyl)-3-(3,4-dimethoxystyryl)-5-(3,4-dimethoxyphen yl)-pyrazoline,
1-(4-tert-butyl-phenyl)-3-(2,6-dimethoxystyryl)-5-(2,6-dimethoxyphen yl)-pyrazoline,
1-(4-tert-butyl-phenyl)-3-(2,5-dimethoxystyryl)-5-(2,5-dimethoxyphen yl)-pyrazoline,
1-(4-tert-butyl-phenyl)-3-(2,3-dimethoxystyryl)-5-(2,3-dimethoxyphen yl)-pyrazoline,
1-(4-tert-butyl-phenyl)-3-(2,4-dimethoxystyryl)-5-(2,4-dimethoxyphen yl)-pyrazoline,
1-(4-isopropyl-phenyl)-3-(3,5-dimethoxystyryl)-5-(3,5-dimethoxyphen yl)-pyrazoline,
1-(4-isopropyl-phenyl)-3-(3,4-dimethoxystyryl)-5-(3,4-dimethoxyphen yl)-pyrazoline,
1-(4-isopropyl-phenyl)-3-(2,6-dimethoxystyryl)-5-(2,6-dimethoxyphen yl)-pyrazoline,
1-(4-isopropyl-phenyl)-3-(2,5-dimethoxystyryl)-5-(2,5-dimethoxyphen yl)-pyrazoline,
1-(4-isopropyl-phenyl)-3-(2,3-dimethoxystyryl)-5-(2,3-dimethoxyphen yl)-pyrazoline, and
1-(4-isopropyl-phenyl)-3-(2,4-dimethoxystyryl)-5-(2,4-dimethoxyphen yl)-pyrazoline.

Examples of the anthracene compound include
1-methylanthracene, 2-methylanthracene, 9-methylanthracene,
2-ethylanthracene, 2-butylanthracene, 9-vinylanthracene,
9-phenylanthracene, 1-aminoanthracene, 2-aminoanthracene,
9-(methylaminomethyl)anthracene, 9-acetylanthracene,
9-anthraldehyde, 9,10-dimethylanthracene, 9,10-dimethoxyanthracene,
9,10-diethoxyanthracene, 9,10-dipropoxyanthracene,
9,10-dibutoxyanthracene, 9,10-dipentoxyanthracene,
9,10-di(2-ethylhexyloxy)anthracene, 9,10-diphenylanthracene, 2-bromo-9,10-diphenylanthracene,
9-(4-bromophenyl)-10-phenylanthracene, 10-methyl-9-anthraldehyde, and 1,4,9,10-tetrahydroxyanthracene.

Examples of the coumarin compound include 3-benzoyl-7-diethylaminocoumarin, 7-diethylamino-4-methylcoumarin, and 3,3'-carbonylbis(7-diethylaminocoumarin).

From the viewpoint of adhesiveness, resolution, and a high aspect ratio, the component (D) may include at least one selected from the group consisting of a dialkylaminobenzophenone compound, apyrazoline compound, and an anthracene compound. From the viewpoint of releasability, the component (D) may include a dialkylaminobenzophenone compound.

From the viewpoint of adhesiveness, resolution, and a high aspect ratio, the content of the component (D) is less than 0.01 parts by mass, and may be 0.009 parts by mass or less, 0.008 parts by mass or less, 0.007 parts by mass or less, or 0.006 parts by mass or less, with respect to 100 parts by mass of the total amount of the component (A) and the component (B). From the viewpoint of sensitivity, the content of the component (D) may be 0.001 parts by mass or more, 0.002 parts by mass or more, 0.003 parts by mass or more, or 0.004 parts by mass or more, with respect to 100 parts by mass of the total amount of the component (A) and the component (B).

From the viewpoint of adhesiveness, resolution, and a high aspect ratio, the content of the component (D) may be 0.65 parts by mass or less, 0.60 parts by mass or less, 0.50 parts by mass or less, 0.40 parts by mass or less, 0.30 parts by mass or less, or 0.20 parts by mass or less, with respect to 100 parts by mass of the total amount of the component (C).

### Component (E): Polymerization inhibitor

From the viewpoint of suppressing polymerization at an unexposed part during the formation of a resist pattern and improving the resolution, the photosensitive resin composition may further contain component (E): a polymerization inhibitor. The polymerization inhibitor may be, for example, 4-tert-butylcatechol or 2,2,6,6-tetramethyl-4-hydroxypiperidine-1-oxyl.

The content of the component (E) may be 0.001 to 0.10 parts by mass, 0.005 to 0.08 parts by mass, or 0.01 to 0.06 parts by mass, with respect to 100 parts by mass of the total amount of the component (A) and the component (B).

The photosensitive resin composition may further contain one kind or two or more kinds of other components in addition to the above-mentioned components. Examples of the other components include hydrogen donors (bis[4-(dimethylamino)phenyl]methane, bis[4-(diethylamino)phenyl]methane, Leuco Crystal Violet, N-phenylglycine, and the like), dyes (Malachite Green and the like), photochromic agents (tribromophenylsulfone, Leuco Crystal Violet, and the like), thermal color development inhibitors, plasticizers (p-toluenesulfonamide and the like), pigments, fillers, antifoaming agents, flame retardants, stabilizers, adhesion promoters, leveling agents, peeling accelerators, antioxidants, fragrances, imaging agents, and thermal cross-linking agents. The content of the other components may be 0.005 parts by mass or more or 0.01 parts by mass or more, and may be 20 parts by mass or less, with respect to 100 parts by mass of the total amount of the component (A) and the component (B).

From the viewpoint of adjusting the viscosity, the photosensitive resin composition may further contain one kind or two or more kinds of organic solvents. Examples of the organic solvent include methanol, ethanol, acetone, methyl ethyl ketone, methyl cellosolve, ethyl cellosolve, toluene, N,N-dimethylformamide, and propylene glycol monomethyl ether. The content of the organic solvent may be 40% by mass or more or may be 70% by mass or less, based on the total amount of the photosensitive resin composition.

The photosensitive resin composition can be suitably used for forming a resist pattern, and can be especially suitably used in the method for producing a wiring board that will be described below.

### [Photosensitive element]

A photosensitive element according to the present embodiment includes a support, and a photosensitive layer formed on the support using the above-described photosensitive resin composition. The solid content of each contained component other than volatile substances in the photosensitive layer may be within the numerical value range of the solid content of each contained component in the above-mentioned photosensitive resin composition. When the photosensitive element according to the present embodiment is used, the photosensitive layer may be laminated on a substrate and then exposed without peeling the support. Fig. 1 is a schematic cross-sectional view of the photosensitive element according to an embodiment. As shown in Fig. 1, the photosensitive element 1 is configured to include a support 2, and a photosensitive layer 3 formed on the support 2 and derived from the above-described photosensitive resin composition, and to include other layers such as a protective layer 4, which are provided as necessary.

The support 2 and the protective layer 4 may be each a polymer film having heat resistance and solvent resistance, and may be, for example, a polyester film such as a polyethylene terephthalate film; or a polyolefin film such as a polyethylene film or a polypropylene film. The support 2 and the protective layer 4 may be each a film of a hydrocarbon-based polymer other than a polyolefin. A film of a hydrocarbon-based polymer including a polyolefin may have a low density and may have a density of, for example, 1.014 g/cm³ or less. The support 2 and the protective layer 4 may be each a stretched film obtained by stretching the low-density hydrocarbon-based polymer film. The type of the of the polymer film constituting the protective layer 4 may be the same as or different from the type of the polymer film constituting the support 2.

These polymer films can be purchased as, for example, polyethylene terephthalate films such as PS series (for example, PS-25) manufactured by Teijin, Ltd., polyethylene films such as NF-15 manufactured by Tamapoly Co., Ltd., or polypropylene films manufactured by Oji Paper Co., Ltd. (for example, ALPHAN MA-410 and E-200C) and Shin-Etsu Film Co., Ltd., respectively.

From the viewpoint that damage to the support 2 can be suppressed when the support 2 is peeled from the photosensitive layer 3, the thickness of the support 2 may be 1 µm or more or 5 µm or more, and from the viewpoint that exposure can be suitably achieved when exposure is performed through the support 2, the thickness may be 100 µm or less, 50 µm or less, or 30 µm or less.

From the viewpoint that damage to the protective layer 4 can be suppressed when the photosensitive layer 3 and the support 2 are laminated on a substrate while peeling the protective layer 4, the thickness of the protective layer 4 may be 1 µm or more, 5 µm or more, or 15 µm or more, and from the viewpoint that productivity is improved, the thickness may be 100 µm or less, 50 µm or less, or 30 µm or less.

The photosensitive layer 3 is formed using the above-mentioned photosensitive resin composition. From the viewpoint of forming a resist pattern as a thick film, the thickness after drying of the photosensitive layer 3 (in a case where the photosensitive resin composition contains an organic solvent, after the organic solvent is volatilized) may be 30 µm or more, 35 µm or more, 40 µm or more, 45 µm or more, 50 µm or more, 60 µm or more, 70 µm or more, or 80 µm or more, and from the viewpoint of adhesiveness, resolution, and a high aspect ratio, the thickness may be 500 µm or less, 450 µm or less, 400 µm or less, 350 µm or less, or 300 µm or less.

The photosensitive element 1 can be obtained, for example, in the following manner. First, a photosensitive layer 3 is formed on a support 2. The photosensitive layer 3 can be formed by, for example, applying a photosensitive resin composition containing an organic solvent to form a coating layer, and drying this coating layer. Next, a protective layer 4 is formed on a surface of the photosensitive layer 3 on the opposite side of the support 2.

The coating layer is formed by, for example, a known method such as roll coating, comma coating, gravure coating, air knife coating, die coating, or bar coating. Drying of the coating layer is carried out such that the amount of the organic solvent remaining in the photosensitive layer 3 is, for example, 2% by mass or less, and specifically, drying is carried out, for example, at 70°C to 150°C for 5 to 30 minutes.

According to another embodiment, the photosensitive element does not have to include a protective layer, and may further include other layers such as a cushion layer, an adhesive layer, a light absorbing layer, and a gas barrier layer.

The photosensitive element 1 may be, for example, in a sheet form, or may be in the form of a photosensitive element roll wound in a roll form around a core. With regard to the photosensitive element roll, the photosensitive element 1 is preferably wound such that the support 2 is on the outside. The core is formed from, for example, polyethylene, polypropylene, polystyrene, polyvinyl chloride, or an acrylonitrile-butadiene-styrene copolymer. From the viewpoint of protecting end faces, an end face separator may be provided on the end faces of the photosensitive element roll, and from the viewpoint of edge fusion resistance, a moisture-proof end face separator may be provided. The photosensitive element 1 may be wrapped in, for example, a black sheet with low moisture permeability.

The photosensitive element 1 can be suitably used for forming a resist pattern, and can be especially suitably used in the method for producing a printed wiring board that will be described below.

### [Method for forming resist pattern]

A method for forming a resist pattern of the present embodiment includes: a step of forming a photosensitive layer on a substrate using the above-described photosensitive resin composition or the above-described photosensitive element (photosensitive layer forming step); a step of irradiating at least a portion (predetermined portion) of the above-described photosensitive layer with active light rays to form a photocured part (exposure step); and a step of removing at least a portion of a non-photocured part of the above-described photosensitive layer from the above-described substrate (development step), and the method may also be configured to include other steps as necessary. A resist pattern can be referred to as a photocured product pattern of a photosensitive resin composition and can also be referred to as a relief pattern. The method for forming a resist pattern can also be referred to as a method for producing a resist pattern-attached substrate.

### (Photosensitive layer forming step)

Regarding a method for forming a photosensitive layer on a substrate, for example, the above-described photosensitive resin composition may be applied and dried, or after the protective layer is removed from the above-described photosensitive element, and then the photosensitive layer of the photosensitive element may be pressure-bonded onto the above-described substrate while heating. When a photosensitive element is used, a laminated body composed of a substrate, a photosensitive layer, and a support, in which these are laminated in this order, is obtained. The above-described substrate is not particularly limited; however, usually, a substrate for circuit formation including an insulating layer and a conductor layer formed on the insulating layer, or a die pad (base material for a lead frame) such as an alloy base material is used.

When a photosensitive element is used, the photosensitive layer forming step may be carried out under reduced pressure from the viewpoint of adhesiveness and followability. Heating of the photosensitive layer and/or the substrate at the time of pressure-bonding may be carried out at a temperature of 70°C to 130°C. Pressure-bonding may be carried out at a pressure of about 0.1 to 1.0 MPa (about 1 to 10 kgf/cm²); however, these conditions are appropriately selected as necessary. Incidentally, when the photosensitive layer is heated to 70°C to 130°C, it is not necessary to subject the substrate to a preheating treatment in advance; however, in order to further improve adhesiveness and followability, a preheating treatment of the substrate can be carried out.

### (Exposure step)

In the exposure step, when at least a portion of the photosensitive layer formed on the substrate is irradiated with active light rays, the portions irradiated with active light rays are photocured, and a latent image is formed. At this time, in a case where a support is present on the photosensitive layer, when the support is transparent to active light rays, the active light rays can be irradiated through the support; however, when the support is opaque, the photosensitive layer is irradiated with active light rays after the support is removed.

Examples of the exposure method include a method of irradiating active light rays in an image-wise manner by a direct drawing exposure method such as an LDI (Laser Direct Imaging) exposure method or a DLP (Digital Light Processing) exposure method, a method of irradiating active light rays in an image-wise manner through a negative or positive mask pattern called artwork (mask exposure method), and a method of irradiating active light rays in an image-wise manner by a projection exposure method.

As the light source for the active light rays, any known light source can be used, and for example, light sources that effectively emit ultraviolet radiation and visible light, such as a carbon arc lamp, a mercury vapor arc lamp, a high-pressure mercury lamp, a xenon lamp, a gas laser such as an argon laser, a solid-state laser such as a YAG laser, and a semiconductor laser, are used.

### (Development step)

In the development step, as at least a portion of a non-photocured part (other than a photocured part) of the above-described photosensitive layer is removed from the substrate, a resist pattern is formed on the substrate.

In a case where a support is present on the photosensitive layer, removal (development) of a region other than the above-described photocured part (may also be referred to as an unexposed portion) is carried out after the support is removed. Development methods include wet development and dry development; however, wet development is widely used.

When wet development is employed, development may be carried out by a known development method using a developing solution suitable for the photosensitive resin composition. Examples of the development method include methods using a dipping method, a paddle method, a spray method, and methods using brushing, scrubbing, rocking immersion, and the like. From the viewpoint of resolution, a high-pressure spray method may be used as the development method. Two or more kinds of these methods may be used in combination to perform development.

The configuration of the developing solution is appropriately selected according to the configuration of the above-described photosensitive resin composition. Examples of the developing solution include an alkaline aqueous solution and an organic solvent developing solution.

In view of safety, stability, and satisfactory operability, an alkaline aqueous solution may be used as the developing solution. As the base of the alkaline aqueous solution, an alkali hydroxide such as hydroxides of lithium, sodium, or potassium; an alkali carbonate such as carbonate or bicarbonate of lithium, sodium, potassium, or ammonium; an alkali metal phosphate such as potassium phosphate or sodium phosphate; an alkali metal pyrophosphate such as sodium pyrophosphate or potassium pyrophosphate; sodium borate, sodium metasilicate, tetramethylammonium hydroxide, ethanolamine, ethylenediamine, diethylenetriamine, 2-amino-2-hydroxymethyl-1,3-propanediol, 1,3-diaminopropanol-2, morpholine, and the like are used.

As the alkaline aqueous solution used for development, for example, a dilute solution of 0.1% to 5% by mass of sodium carbonate, a dilute solution of 0.1% to 5% by mass of potassium carbonate, a dilute solution of 0.1% to 5% by mass of sodium hydroxide, or a dilute solution of 0.1% to 5% by mass of sodium tetraborate can be used. The pH of the alkaline aqueous solution may be in the range of 9 to 11, and the temperature can be regulated in accordance with the alkali developability of the photosensitive layer. In the alkaline aqueous solution, for example, a surface active agent, an antifoaming agent, a small amount of an organic solvent for promoting development, and the like may be incorporated.

Examples of the organic solvent used for the alkaline aqueous solution include acetone, ethyl acetate, an alkoxyethanol having an alkoxy group having 1 to 4 carbon atoms, ethyl alcohol, isopropyl alcohol, butyl alcohol, diethylene glycol monomethyl ether, diethylene glycol monoethyl ether, and diethylene glycol monobutyl ether.

Examples of the organic solvent used for the organic solvent developing solution include 1,1,1-trichloroethane, N-methyl-2-pyrrolidone, N, N-dimethylformamide, cyclohexanone, methyl isobutyl ketone, and γ-butyrolactone. From the viewpoint of preventing ignition, these organic solvents may be used as organic solvent developing solutions by adding water in an amount in the range of 1% to 20% by mass.

The method for forming a resist pattern according to the present embodiment may include, after removing uncured portions in the development step, a step of further curing the resist pattern by performing heating at about 60°C to 250°C or exposure at a dose of about 0.2 to 10 J/cm² as necessary.

### [Method for producing printed wiring board]

A method for producing a printed wiring board according to the present embodiment includes a step of subjecting a substrate on which a resist pattern has been formed by the above-described method for forming a resist pattern, to an etching treatment or a plating treatment to form a conductor pattern, and may be configured to include other steps such as a resist pattern removal step as necessary.

In the plating treatment, the conductor layer provided on the substrate is subjected to a plating treatment by using the resist pattern formed on the substrate as a mask. After the plating treatment, the resist is removed by removal of the resist pattern that will be described below, the conductor layer covered by this resist may be etched to form a conductor pattern. The method for the plating treatment may be an electrolytic plating treatment or an electroless plating treatment, and the plating treatment may be an electroless plating treatment.

On the other hand, in the etching treatment, the conductor layer provided on the substrate is removed by etching using the resist pattern formed on the substrate as a mask, and a conductor pattern is formed. The method for the etching treatment is appropriately selected depending on the conductor layer to be removed. Examples of the etching solution include a cupric chloride solution, a ferric chloride solution, an alkali etching solution, and a hydrogen peroxide-based etching solution.

After the etching treatment or plating treatment, the resist pattern on the substrate may be removed. For the removal of the resist pattern, for example, the resist pattern can be removed by using a more strongly alkaline aqueous solution than the above-described alkaline aqueous solution used for the development step. As the strongly alkaline aqueous solution, for example, a 1% to 10% by mass aqueous solution of sodium hydroxide or a 1% to 10% by mass aqueous solution of potassium hydroxide is used.

In a case where the resist pattern is removed after applying a plating treatment, a desired printed wiring board can be produced by further etching the conductor layer covered with the resist through an etching treatment and forming a conductor pattern. The method for the etching treatment at this time is appropriately selected depending on the conductor layer to be removed. For example, the above-mentioned etching solution can be applied.

The method for producing a printed wiring board according to the present embodiment can be applied to the production of single-layer printed wiring boards as well as multilayer printed wiring boards, and can also be applied to the production of printed wiring boards having small diameter through-holes.

### EXAMPLES

Hereinafter, the present disclosure will be more specifically described by way of Examples; however, the present invention is not intended to be limited to these Examples.

### [Synthesis of binder polymer]

As polymerizable monomers, compounds whose homopolymers have the following Tg were prepared.
AA: Acrylic acid (Tg: 106°C)
MAA: Methacrylic acid (Tg: 228°C)
ST: Styrene (Tg: 100°C)
TCDMA: Dicyclopentanyl methacrylate (Tg: 175°C)
HEMA: Hydroxyethyl methacrylate (Tg: 55°C)
BZMA: Benzyl methacrylate (Tg: 54°C)

### (Synthesis Example 1)

100.4 g of acrylic acid (AA), 308.9 g of styrene (ST), and 29.7 g of dicyclopentanyl methacrylate (TCDMA) (mass ratio of AA/ST/TCDMA = 23/70/7) as polymerizable monomers were mixed with 2.2 g of azobisisobutyronitrile (AIBN) as a thermal radical polymerization initiator and 129.5 g of propylene glycol monomethyl ether as a solvent, and a mixture (x) was prepared. 5.5 g of AIBN was dissolved in 26.3 g of propylene glycol monomethyl ether to prepare a solution (a).

In a flask equipped with a stirring device, a dropping funnel, a condenser, a thermometer, and a gas inlet tube, 45.6 g of propylene glycol monomethyl ether and 175.1 g of toluene were added and stirred in a nitrogen atmosphere while performing gas replacement, and the temperature was raised to 80°C. Next, the mixture (x) was added dropwise into the flask over 2 hours. After the dropping was completed, the mixture was stirred at 80°C for 2 hours, subsequently the solution (a) was added thereto, and the resulting mixture was further stirred for 3 hours. Next, while continuing stirring, the solution in the flask was heated up to 100°C for 20 minutes, and then stirred at 100°C for 2 hours. Next, 93.7 g of propylene glycol monomethyl ether and 74.3 g of toluene were added thereto, and the mixture was cooled to room temperature while being stirred, to obtain a solution of binder polymer (A-1) (solid content: 50% by mass).

### (Synthesis Examples 2 to 5)

Solutions of binder polymers (A-2) to (A-5) (solid content: 50% by mass) were obtained under the same conditions as in Synthesis Example 1, except that the types and amounts of the polymerizable monomers of the mixture (x) were changed to the polymerizable monomers and mass ratios shown in Table 1.

**[Table 1]**

| Binder polymer | | A-1 | A-2 | A-3 | A-4 | A-5 |
|---|---|---|---|---|---|---|
| Polymerizable monomer | AA | 23 | - | 27 | 28 | - |
| | MAA | - | 27 | - | - | 23 |
| | ST | 70 | 50 | 50 | 65 | 70 |
| | TCDMA | 7 | - | - | 7 | 7 |
| | HEMA | - | 3 | 3 | - | - |
| | BZMA | - | 20 | 20 | - | - |
| Mw | | 40000 | 35000 | 40000 | 40000 | 40000 |
| Tg(°C) | | 106 | 114 | 92 | 108 | 131 |
| Acid value(mgKOH/g) | | 176 | 174 | 210 | 218 | 150 |

### (Weight average molecular weight)

As a sample for Mw measurement, the polymer solution was dissolved in tetrahydrofuran (THF) to prepare a 0.2% by mass THF solution. The Mw was derived by measurement according to a gel permeation chromatography (GPC) method and calculation using a calibration curve of polystyrene standards. The conditions for GPC are shown below.
Measuring apparatus: SHODEX (registered trademark) GPC-101 (manufactured by Resonac Corporation)
Detector: Differential refractometer SHODEX RI-71S (manufactured by Resonac Corporation)
Column: SHODEX LF-804+LF-804 (manufactured by Resonac Corporation)
Column temperature: 40°C
Eluent: THF
Flow rate: 1 mL/min

### (Glass transition temperature)

The Tg of the binder polymer was calculated from the Fox equation.

### (Acid value)

According to JIS K6901:2008 5.3.2, the acid value of the binder polymer was measured by a neutralization titration method.

### [Photosensitive resin composition]

57.0 parts by mass of the solid content of a binder polymer solution was mixed with each component in the blending amount (parts by mass) shown in Table 2 and a sensitizer (EAB: 4,4'-bis(diethylamino)benzophenone (manufactured by Hodogaya Chemical Co., Ltd.); pyrazoline: 1-phenyl-3-(4-methoxystyryl)-5-(4-methoxyphenyl)pyrazoline (manufactured by Nippon Chemical Works Co., Ltd., trade name "PZ-501D")) in the blending amounts shown in Table 3 and Table 4 to prepare photosensitive resin compositions. The details of each component shown in Table 2 are as follows.

**[Table 2]**

| | |
|---|---|
| FA-321M | 34.5 |
| FA-024M | 2.5 |
| BP-2EM | 6.0 |
| B-CIM | 2.9 |
| Q-TBC-5P | 0.04 |
| LA-7RD | 0.01 |
| LCV | 0.3 |
| SF-808H | 1.0 |
| MKG | 0.03 |
| Acetone | 10 |
| Toluene | 10 |
| Methanol | 6 |

### (Photopolymerizable compound)

FA-321M:
   2,2-Bis(4-(methacryloxypentaethoxy)phenyl)propane (manufactured by Resonac Corporation)
FA-024M: EO·PO-modified dimethacrylate (manufactured by Resonac Corporation)
BP-2EM: 2,2-Bis(4-(methacryloxydiethoxy)phenyl)propane (manufactured by Kyoeisha Chemical Co., Ltd.)

### (Photopolymerization initiator)

B-CIM:
2,2'-Bis(2-chlorophenyl)-4,4',5,5'-tetraphenylbiimidazole (manufactured by Hampford Research, Inc.)

### (Polymerization inhibitor)

Q-TBC-5P: 4-tert-butylcatechol (manufactured by DIC Corporation)
LA-7RD: 2,2,6,6-Tetramethyl-4-hydroxypiperidine-1-oxyl (manufactured by ADEKA Corporation)

### (Photochromic agent)

LCV: Leuco Crystal Violet (manufactured by Yamada Chemical Co., Ltd.)

### (Adhesion promoter)

SF-808H: Mixture of carboxybenzotriazole, 5-amino-1H-tetrazole, and methoxypropanol (manufactured by Sanwa Kasei Corporation)

### (Dye)

MKG: Malachite Green (manufactured by Osaka Organic Chemical Industry, Ltd.)

### [Photosensitive element]

A polyethylene terephthalate film (manufactured by Toray Industries, Inc., trade name "QS-69") having a thickness of 16 µm was prepared as a support. A photosensitive resin composition was applied on the support and then sequentially dried in hot air convection type dryers at 80°C and 120°C to form a photosensitive layer having the thickness shown in Table 3 or Table 4. A polyethylene film (manufactured by Tamapoly Co., Ltd., trade name "NF-15") as a protective layer was stuck onto this photosensitive layer, and a photosensitive element in which a support, a photosensitive layer, and a protective layer were laminated in this order was obtained.

### [Laminated body]

A copper-clad laminated plate (manufactured by Resonac Corporation, trade name "MCL-E-679"), which is a glass epoxy material having a copper foil (thickness: 35 µm) laminated on both surfaces, was surface-treated by washing with water, washing with acid, and washing with water, and then dried under an airflow. The surface-treated copper-clad laminated plate was heated to 80°C, and while the protective layer was peeled, the photosensitive element was laminated on the copper-clad laminated plate such that the photosensitive layer was in contact with the copper surface. As a result, a laminated body in which a copper-clad laminated plate, a photosensitive layer, and a support were laminated in this order was obtained. Lamination was carried out using a heating roll at 110°C at a pressure-bonding pressure of 0.4 MPa and a roll speed of 1.05 m/min.

### [Evaluation]

### (Minimum developing time)

The above-described laminated body was cut into a square measuring 5 cm on each side, and a test piece for measuring the minimum developing time was obtained. The support was peeled from the test piece, subsequently the photosensitive layer that had not been exposed was spray-developed at a pressure of 0.15 MPa using a 1% by mass aqueous solution of sodium carbonate at 30°C, and the shortest time in which it could be checked by visual inspection that an unexposed part of 1 mm or more had been removed, was defined as minimum developing time (unit: seconds). For the nozzle in the spray development, a full cone type nozzle was used. The distance between the above-described test piece and the nozzle tip was 6 cm, and the test piece and the nozzle were arranged such that the center of the test piece coincided with the center of the nozzle. A shorter minimum developing time means more satisfactory developability. The results are shown in Table 3 and Table 4.

### (Adhesiveness)

A test pattern with a ratio of line width (L)/space width (S) of x/3x (x = 1 to 100, unit: µm, changing at intervals of 1 µm) as a negative mask for adhesiveness evaluation was placed on the support of the above-described laminated body, and exposure was carried out using a parallel light exposure apparatus (manufactured by ORC Manufacturing Co., Ltd., trade name "EXM-1201") that used a high-pressure mercury lamp as a light source, at an exposure dose at which the number of remaining steps of a Hitachi 41-step tablet reached 14 steps.

After the exposure, the support was peeled from the laminated body, the photosensitive layer was exposed, and an unexposed portion was removed by spraying a 1% by mass aqueous solution of sodium carbonate at 30°C for 50 seconds. After the development, the adhesiveness was evaluated by using the minimum value (unit: µm) among the line widths in a resist pattern in which the space portions (unexposed portions) were removed without any residue, and the line portions (exposed portions) were formed without causing any meandering and chipping. As this numerical value is smaller, it is implied that the adhesiveness is more satisfactory. Furthermore, the ratio of the thickness of the resist pattern to this numerical value (aspect ratio of the resist pattern) was calculated. The results are shown in Table 3 and Table 4.

### (Resolution)

A mask for resolution evaluation having a pattern in which dots having a diameter of 1 to 100 µm were arranged in a grid pattern, was placed on the support of the above-described laminated body. Thereafter, exposure was carried out using a parallel light exposure apparatus (manufactured by ORC Manufacturing Co., Ltd., trade name "EXM-1201") that used a high-pressure mercury lamp as a light source, at an exposure dose at which the number of remaining steps of a 41-step tablet reached 14 steps.

After the exposure, the support was peeled from the laminated body, the photosensitive layer was exposed, and an unexposed portion was removed by spraying a 1% by mass aqueous solution of sodium carbonate at 30°C for a time twice the minimum developing time (shortest time in which the unexposed portion was removed). As a result, a resist pattern (dot pattern) was formed. Thereafter, the via pattern (via hole pattern) thus formed was observed with an optical microscope and evaluated. The resolution (via pattern) was evaluated by using the value of the smallest via pattern diameter among those via patterns that had been neatly and completely removed (openings) in the via pattern arranged in a grid pattern. As this numerical value is smaller, it is implied that the resolution is satisfactory. Furthermore, the ratio of the thickness of the resist pattern to this resolution (thickness of resist pattern/resolution; hereinafter, also referred to as "aspect ratio of vias") was calculated. The results are shown in Table 3 and Table 4.

### (Releasability)

A chrome-on-glass photomask (having a flat pattern of 45 mm × 60 mm) as a negative mask for releasability test evaluation was placed on the support of the above-described laminated body. Next, exposure was carried out using a parallel light exposure apparatus (manufactured by ORC Manufacturing Co., Ltd., trade name "EXM-1201") that used a high-pressure mercury lamp as a light source, at an exposure dose at which the number of remaining steps of a Hitachi 41-step tablet reached 14 steps.

After the exposure, the support was peeled from the laminated body, the photosensitive layer was exposed, an unexposed portion was removed by spraying a 1% by mass aqueous solution of sodium carbonate at 30°C for a time twice the minimum developing time, and a substrate on which a cured film was formed was obtained. This substrate was left to stand at room temperature for 3 hours and then immersed in an amine-based releasing liquid (aqueous solution of 6% by volume R-100S + 2% by volume R-101, manufactured by Mitsubishi Gas Chemical Co., Inc.) heated to 50°C, and the releasing liquid was stirred at a speed of 400 rpm. The time taken from the start of stirring until the cured film was completely removed from the substrate was defined as releasing time (unit: seconds). A shorter releasing time means more satisfactory releasability. The results are shown in Table 3 and Table 4.

**[Table 3]**

| | Example 1 | Comparative Example 1 | Comparative Example 2 | Example 2 | Comparative Example 3 | Comparative Example 4 | Comparative Example 5 | Comparative Example 6 |
|---|---|---|---|---|---|---|---|---|
| A-1 | 57.0 | - | 57.0 | 57.0 | - | 57.0 | - | 57.0 |
| A-2 | - | 57.0 | - | - | 57.0 | - | 57.0 | - |
| EAB | 0.005 | 0.005 | 0.083 | 0.005 | 0.005 | 0.083 | 0.083 | 0.083 |
| Film thickness of photosensitive layer(µm) | 80 | 80 | 80 | 40 | 40 | 40 | 7 | 7 |
| Developability (seconds) | 47 | 67 | 48 | 23 | 31 | 24 | 7 | 7 |
| Adhesiveness(µm) | 22 | 22 | >50 | 8 | 8 | 25 | 3 | 3 |
| Aspect ratio of resist pattern | 3.6 | 3.6 | - | 5.0 | 5.0 | 1.6 | 2.3 | 2.3 |
| Resolution(µm) | 20 | 20 | 40 | 12 | 12 | 30 | 5 | 5 |
| Aspect ratio of vias | 4.0 | 4.0 | 2.0 | 3.3 | 3.3 | 1.3 | 1.4 | 1.4 |
| Releasability (seconds) | 263 | 364 | 270 | 71 | 101 | 75 | 14 | 14 |

**[Table 4]**

| | Example 3 | Example 4 | Example 5 | Example 6 | Example 7 | Comparative Example 7 |
|---|---|---|---|---|---|---|
| A-1 | - | - | 57.0 | 57.0 | 57.0 | - |
| A-3 | 57.0 | - | - | - | - | - |
| A-4 | - | 57.0 | - | - | - | - |
| A-5 | - | - | - | - | - | 57.0 |
| EAB | 0.005 | 0.005 | 0.001 | 0.009 | - | 0.005 |
| Pyrazoline | - | - | - | - | 0.005 | - |
| Film thickness of photosensitive layer(µm) | 40 | 40 | 40 | 40 | 40 | 40 |
| Developability (seconds) | 19 | 20 | 23 | 23 | 23 | - |
| Adhesiveness(µm) | 18 | 18 | 8 | 9 | 8 | - |
| Aspect ratio of resist pattern | 2.2 | 2.2 | 5.0 | 4.4 | 5.0 | - |
| Resolution(µm) | 10 | 10 | 14 | 11 | 12 | - |
| Aspect ratio of vias | 4.0 | 4.0 | 2.9 | 3.6 | 3.3 | - |
| Releasability (seconds) | 65 | 62 | 70 | 71 | 72 | - |

In Comparative Example 7, since the hydrophobicity and glass transition temperature of the binder polymer were too high, it was incapable of development and incapable of releasing.

### Reference Signs List

1: photosensitive element, 2: support, 3: photosensitive layer, 4: protective layer.

## Claims

1. A photosensitive resin composition comprising:
a binder polymer;
a photopolymerizable compound;
a photopolymerization initiator; and
a sensitizer,
wherein the binder polymer has a structural unit derived from acrylic acid, and
a content of the sensitizer is less than 0.01 parts by mass with respect to 100 parts by mass of a total amount of the binder polymer and the photopolymerizable compound.

2. The photosensitive resin composition according to claim 1, wherein the content of the sensitizer is 0.65 parts by mass or less with respect to 100 parts by mass of a total amount of the photopolymerization initiator.

3. The photosensitive resin composition according to claim 1, wherein the content of the sensitizer is 0.001 parts by mass or more with respect to 100 parts by mass of the total amount of the binder polymer and the photopolymerizable compound.

4. The photosensitive resin composition according to claim 1, wherein the binder polymer further has at least one selected from the group consisting of a structural unit derived from styrene or a styrene derivative, and a structural unit derived from a (meth)acrylate compound having an alicyclic structure.

5. The photosensitive resin composition according to claim 1, wherein the sensitizer includes at least one selected from the group consisting of a dialkylaminobenzophenone compound, a pyrazoline compound, and an anthracene compound.

6. A photosensitive element comprising:
a support; and
a photosensitive layer formed on the support using the photosensitive resin composition according to any one of claims 1 to 5.

7. The photosensitive element according to claim 6, wherein the photosensitive layer has a thickness of 30 µm or more.

8. A method for forming a resist pattern, the method comprising:
a step of forming a photosensitive layer on a substrate by using the photosensitive resin composition according to any one of claims 1 to 5;
a step of irradiating at least a portion of the photosensitive layer with active light rays to form a photocured part; and
a step of removing a non-photocured part of the photosensitive layer from the substrate to form a resist pattern.

9. A method for forming a resist pattern, the method comprising:
a step of forming a photosensitive layer on a substrate using the photosensitive element according to claim 6;
a step of irradiating at least a portion of the photosensitive layer with active light rays to form a photocured part; and
a step of removing a non-photocured part of the photosensitive layer from the substrate to form a resist pattern.

10. A method for producing a printed wiring board, the method comprising:
a step of subjecting a substrate on which a resist pattern has been formed by the method for forming a resist pattern according to claim 8, to an etching treatment or a plating treatment to form a conductor pattern.

11. A method for producing a printed wiring board, the method comprising:
a step of subjecting a substrate on which a resist pattern has been formed by the method for forming a resist pattern according to claim 9, to an etching treatment or a plating treatment to form a conductor pattern.
